# EUROPEAN PATENT APPLICATION

(11) **EP 4 836 622 A2**
(43) Date of publication of application: **04.11.2026**
(21) Application number: 26205256.6
(22) Date of filing: 31.05.2022
(51) Int. Cl.: H05K 7/20

(54) **MODULAR COLD PLATE**

(62) Document number(s) of the earlier application(s) in accordance with Art. 76 EPC: 22176371.7 / 4 287 798
(71) Applicant: Hitachi Energy Ltd, 8050 Zürich (CH)
(72) Inventor: Hosain, Lokman, 724 79 Västerås (SE); Bel Fdhila, Rebei, 724 76 Västerås (SE); Girlanda, Orlando, 723 56 Västerås (SE); Maleksaeedi, Saeed, Waterloo, N2V 2M5 (CA)
(74) Representative: AWA Sweden AB

(57) **Abstract**

An arrangement (100) and a method (1000) for assembling the arrangement are provided. The modular cold plate arrangement is configured to cool an electronic component. The arrangement comprises a base plate (110) comprising an enclosure (120) configured to hold a cooling fluid. The arrangement further comprises a fluid inlet (130) configured to allow a cooling fluid to enter the enclosure. The arrangement further comprises a fluid outlet (140) configured to allow the cooling fluid to leave the enclosure. The arrangement further comprises a plurality of thermal module plates (150) arranged in the enclosure formed in the base plate. At least one of the plurality of the thermal module plates comprises a heat transfer structure (160) configured to transfer heat from the electronic component to the cooling fluid.

## Description

### FIELD OF THE INVENTION

The present invention relates to the field of cold plates, and in particular to cold plates with modular components and a method for assembling a cold plate.

### BACKGROUND OF THE INVENTION

Cold plates are a standard part of electronics cooling and are used to cool electronics components in a variety of fields. Cold plates may for example provide localized cooling of electronics by transferring heat from the device to a fluid. The fluid may then flow to a remote heat exchanger where the heat may dissipate. Cold plates may be used for any system needed of cooling, for example for electronic systems such as power electronics.

Electric power transmission systems, such as for example High-Voltage Direct Current (HVDC) transmission system, are used to transmit electric power long distances. These systems have components generating heat and therefore cold plates may be used. Heat may for example be generated when the direct current is transformed to alternating current.

Cold plates for HVDC systems found in the prior art may for example have cooling channels that are milled in large aluminium blocks. An issue with this solution is the low versatility of the system due to restrictions related to the shapes and sizes of the channels.

It is therefore of interest to provide an updated alternative for cooling components for electric power transmission systems such as HVDC systems that increases the versatility of the cold plate.

### SUMMARY OF THE INVENTION

The inventors have reached the conclusion that it would be advantageous to have a cold plate that can be altered depending on the position of the heat source and the amount of produced heat. The present invention at least partially solves the problem by providing a modular cold plate arrangement that allows the cooling elements to be placed directly under the heat source.

The cold plate arrangement can for example be used for electronics, such as power electronics. Power electronics are used in different applications and in many different fields. Generally, high power applications require liquid cooling of power electronics. Power electronics can during use reach high temperatures that need to be taken care of in order to avoid damages to the systems. Liquid or fluid cooling may allow sufficient cooling while maintaining mechanical integrity of the system. Assembling power electronic components on cold plates or heat sinks is well known in the art. Current heat sinks or cold plates are however not adjusted for customization for the specific component being, or including power electronic components and needed to be cooled. In, for example, HVDC applications different cooling requirements are needed depending on the number of submodules, i.e. the heat generating regions of a power electronic system or component. For example, a HVDC converter, that uses power electronic components (for example thyristors or transistors such as insulated-gate bipolar transistors) to convert alternating current to direct current or vice versa, may have certain cooling requirements which may be hard to solve using today's cold plates.

Further, in a heat sink or cold plate using a cooling fluid there is often a balance between good heat dissipation and pressure drop in the cooling fluid. The cooling fluid used in order to remove heat from the cold plate is pressurized and when it interacts with the cold plate there will be a pressure drop. The cooling fluid is pressurized so that it can move through the cold plate. It may for example be pressurized by means of any standard pump. Due to hydrodynamic resistance within the cold plate the cooling fluid will experience a pressure drop and the fluid exiting the cold plate will generally have a lower pressure than the fluid entering the cold plate. Often, while increasing the heat transfer performance of a cold plate, for example by adding more components that can transfer heat in the flow of the cooling fluid, the pressure drop is also increased which may be problematic.

It is therefore a goal of the present disclosure to provide an arrangement and a method which may provide an adjustable and more effective cooling of electronics.

To achieve this goal, the present disclosure provides an arrangement comprising a base plate, a fluid inlet and fluid outlet, and a plurality of thermal module plates, and a method for assembling the arrangement, as defined by the independent claims. Further embodiments are provided in the dependent claims.

According to a first aspect of the present disclosure, a modular cold plate arrangement configured to cool an electronic component is provided. The modular cold plate arrangement comprises a base plate comprising an enclosure configured to hold a cooling fluid. The modular cold plate arrangement further comprises a fluid inlet configured to allow a cooling fluid to enter the enclosure. The modular cold plate arrangement further comprises a fluid outlet configured to allow the cooling fluid to leave the enclosure. The modular cold plate arrangement further comprises a plurality of thermal module plates arranged in the enclosure formed in the base plate. At least one of the plurality of thermal module plates comprises a heat transfer structure configured to transfer heat from the power electronic component to the cooling fluid.

According to a second aspect of the present disclosure, a method for assembling a modular cold plate arrangement is provided. The method comprises providing a base plate with an enclosure configured to receive at least one thermal module plate. The method further comprises placing at least one thermal module plate within the enclosure at a location matching a position of a heated region of a power electronic component configured to be cooled.

By electronic component it is herein meant any electronics in need of cooling, such as a power electronic component or something using power electronic components. By power electronic component, it is herein meant any power electronic component that may need cooling. Power electronics may for example be used in applications in fields such as high voltage direct current (HVDC) applications and power conversion for wind and solar plants. The power electronic component may for example be, or consist of a number of submodules that generate heat during use. Depending on the placement of the submodules and the number of submodules the cooling capabilities of the modular cold plate arrangement may need to be varied. The submodules may for example be semiconductor modules.

By cooling fluid, it is herein meant a fluid that can be used in a cold plate in order to transfer heat. The fluid may be any fluid, such as a liquid or a gas. The fluid may for example be a naturally occurring fluid such as water, or an especially manufactured cooling fluid for use in cold plates.

By heat transfer structure, it is herein meant any structure that can be at least partially submerged in a cooling fluid for transferring heat to the cooling fluid. A heat transfer structure may for example be a pin-fin configuration or similar, as will be made clear from the description.

Thus, there are provided an arrangement and a method with the function to cool, with a plurality of thermal module plates, an electronic component. The need for reliable energy sources is growing, and the need for transporting power long distances is also growing continually. This brings a need for streamlining the cooling of electronics and power electronics components. By providing a modular cold plate arrangement and a method for assembling such an arrangement the present invention is advantageous since it allows for an individually tailored cold plate for different electronics. The plurality of thermal module plates may for example be arranged in positions such that they match heated regions of the electronics to be cooled. This may be advantageous in that certain materials preferred for cooling electronics may be expensive or rare, and by allowing optimal placements of these plates costs can be kept at a minimum while still providing optimal cooling. A further advantage with the present invention is that it may provide optimal cooling without effecting the pressure drop in a suboptimal way. In general, for a good heat transfer to the cooling fluid cold plates use thermal structures with a maximized area arranged to be submerged in the cooling fluid. The more surface of the thermal structure placed in the cooling fluid, the more heat will be transferred to it. However, by increasing the area or the structures submerged in the cooling fluid, the hydrodynamic resistance is also increased. So, in other words, in general, a high heat transfer brings a larger pressure drop. The present invention brings the advantage of modularity, where the user can place the thermal module plates at advantageous positions in order to maximize the heat transfer at certain positions in the cold plate arrangement. Therefore, if not needed all throughout the cold plate arrangement, other positions may be left empty or filled with pieces that do not affect the pressure drop as much.

According to an embodiment, the heat transfer structure comprises a plurality of pin-fins configured to be at least partially submerged in the cooling fluid to transfer heat to the cooling fluid. The pin-fins may be advantageous since they may provide a large area of the heat transfer structure at least partially submerged in the cooling fluid for maximising the heat dissipation to the cooling fluid. The pin-fins may have any geometry and size. The pin-fins may for example have cross-sections in any shape, the cross-sections may be circular, rectangular, square, diamond-shaped, hexagonal, oval or any other conceivable shape. The pin-fins may be a combination of pin-fins with different shapes, sizes and cross-sections. The pin-fins may further be made from any suitable material, for example a metal such as aluminium.

According to an embodiment, the heat transfer structure comprises a plurality of cells comprising Triply Periodic Minimal Surfaces (TPMS) configured to be at least partially submerged in the cooling fluid to transfer heat to the cooling fluid. The present embodiment may be advantageous since the surface submerged in the cooling fluid may be maximized and the heat dissipation, or heat transfer, to the cooling fluid may be increased. Certain TPMS structures come with inherent features leading to dead-flow zones that may cause particle accumulation and increase in pressure drop. It is envisioned that in certain embodiments these zones are filled with solid material to counteract these dead-flow zones. The modified TPMS-structures may have certain advantages such as better thermal, electrical and load bearing functions than conventional TPMS-structures. In order to create a cell with TPMS one normally has to use additive manufacturing, such as a 3D-printer. It is therefore also envisioned that structures similar to the TPMS may be used instead. These may for example be created by producing parts of the shapes on a sheet of a material, typically metal, and joining the parts later to create the structures. There are many different TPMS-structures available, and any variation may be used in order to create the heat transfer structure.

According to an embodiment, the plurality of cells comprises a gradient in either cell density, cell size or cell type. Depending on the power electronics component to be cooled different degrees of heat dissipation may be needed at different places of the power electronic component. The present embodiment is advantageous since the degree of heat transfer to the cooling liquid can be made to vary throughout the modular cold plate arrangement in order to adjust to the electronic component to be cooled. The gradient may be in any direction of the thermal module plate. The gradient may for example be made in a flow direction of the cooling fluid within the modular cold plate arrangement. The gradient may also be in a direction perpendicular to the flow direction of the cooling fluid.

According to an embodiment, the modular cold plate arrangement further comprises at least one support module plate. At least one of the at least one support module plates comprises at least one channel configured to be at least partially submerged in the cooling fluid. In other words, at least one of the at least one support module plates comprises at least one channel configured to guide the cooling fluid. The thermal module plates may be relatively expensive to make, and it may therefore be advantageous to place these at locations matching the location of heated regions of the electronics to be cooled. In order to completely fill the enclosure, support module plates can then be added to complete the modular cold plate arrangement. The support module plate may be similar to the thermal module plates but may also differ in various aspects. For example, the support module plate may be configured to dissipate heat to the cooling fluid but also to guide the cooling fluid through the cold plate. In comparison, the thermal module plates may be configured to only transfer as much heat as possible to the cooling fluid. By guiding the cooling fluid, as done by the support module plates, the pressure drop in the cooling fluid may not be impacted as much as by the thermal module plates. It may therefore be advantageous with a cold plate arrangement with both thermal module plates and support module plates. Further, in order for the modular cold plate to be able to withstand high pressure the support module plates may be needed to fill the enclosure of the base plate in case it is not filled out by thermal module plates. There may in general be a high pressure on the modular cold plate arrangement to achieve a good contact between the cold plate and the electronics. This to ensure a good heat transfer. Further, the support modular plates may be added to the arrangement in order to ensure that the cooling fluid is kept within the arrangement and cannot escape to ensure an efficient cooling and maintaining the pressure within the cooling fluid. The at least one channel may be formed in any conventional way, for example by straight fins extending in the flow direction of the cooling fluid.

According to an embodiment, the at least one support module plate comprises a plurality of pin-fins, which may be arranged to form the at least one channel. The channels of the support module plates may be used to transfer heat to the cooling fluid as well as to guide or direct the cooling fluid throughout the modular cold plate arrangement. By forming at least one channel using pin-fins the area of material submerged in the cooling fluid may be increased in order to increase the amount of heat dissipated into the cooling fluid. The pin-fins may have any geometry or shape conventional to the field.

According to an embodiment, the base plate further comprises at least one region comprising at least one channel configured to be at least partially submerged in the cooling fluid. The base plate may have one or more regions that are formed in a way to create channels for guiding the cooling fluid. The channels may be similar to the channels of the support module plates. The channels may be integrally formed within the base plate using any manufacturing method,

According to an embodiment, the at least one channel is etched into the base plate. The at least one channel may be formed in the material forming the base plate, it may for example be created by removing material from the base plate. The at least one channel may also be created using any other conventional method for machining a pattern in a piece of metal. Further, the at least one channel may also be made by adding material to the base plate.

According to an embodiment, the at least one region comprises a plurality of pin-fins. And at least one of the at least one channels is formed by the plurality of pin-fins. The channel may be configured to be in contact with the cooling fluid in order to guide the cooling fluid for maintaining a high pressure within the cooling fluid. At the same time the channel will dissipate heat to the cooling fluid. By forming a channel from pin-fins the area dissipating heat may be increased which will provide for a better heat transfer from the cold plate to the cooling liquid.

According to an embodiment, the plurality of pin-fins comprises split pin-fins forming at least one of the at least one channels through the pin-fins for guiding the cooling fluid. The present embodiment is advantageous in that the split pin-fins allow for a better heat transfer to the cooling liquid. By splitting the pin-fins the number of channels may also be increased, which may increase the heat dissipation to the cooling liquid without affecting the pressure drop in a negative way. The cross-sections of the pin-fins may for example be circular, rectangular, square, diamond-shaped, hexagonal, oval or any other conceivable shape.

According to an embodiment, at least one wall of the at least one channel is corrugated. With corrugated, it may be meant wavy, grooved, curvy or similar. The present embodiment is advantageous since it makes sure that the pressure drop is kept as low as possible. When a cooling fluid is pressed forward in a channel with straight walls the pressure drop may increase more than in a channel with corrugated or wavy walls, this may be true for certain dimensions of the channels and features of the cooling fluid. By introducing at least one corrugated, wavy or curvy wall the cross section of the channels (i.e. the part where the cooling fluid flows) can be kept relatively constant which helps with keeping the pressure drop at a minimum as compared to a channel with only straight walls. By using at least one corrugated wall the pressure drop can be kept at a minimum.

According to an embodiment, the cold plate arrangement further comprises a lid portion configured to be arranged in the enclosure on top of the plurality of thermal module plates and the at least one region. The present embodiment may be advantageous in case the modular cold plate arrangement comprises regions in the base plate provided with at least one channel. The lid portion may then be added to ensure that the cooling fluid stays within the enclosure. The lid portion may be configured to be in thermal contact with the electronic component to be cooled and may transfer the heat to the channels and/or pin-fins of the regions machined in the base plate to ensure that these can transfer the heat to the cooling fluid. The channels and/or pin-fins of the regions may have a height allowing them to reach the lid portion when the lid portion is added to the arrangement. The present embodiment may also be advantageous since the plurality of thermal module plates may be manufactured without an individual base plate and may for example only be made out of TPMS cells. The lid portion may then be placed on top of the plurality of thermal module plates and possible support module plates and regions in the base plate to encapsulate the cooling fluid and keep it within the arrangement. The lid portion will then be in contact with the thermal module plates and the channels and/or pin-fins and can therefore transfer heat from the power electronic component to the thermal module plates and the channels and/or pin-fins.

According to an embodiment, the plurality of thermal module plates are distributed within the enclosure to match regions particularly exposed to heating. Different electronic components may have different cooling requirements. For example, an electronic component may include one or more submodules that generate heat during use. It may therefore be advantageous to place the thermal module plates at locations matching the placement of these submodules. The rest of the modular cold plate arrangement may then include support module plates or regions created in the base plate. This can ensure that the pressure drop is kept at a minimum and at the same time that the required heat transfer can be achieved. The submodules may for example be semiconductor modules.

According to an embodiment, the transfer structure of at least one of the plurality of thermal module plates is made using additive manufacturing. The present embodiment may be advantageous especially in case the heat transfer structure includes cells comprising TPMS. This since manufacturing the cells may be simplified using additive manufacturing. Other manufacturing methods are available and may be use for creating the heat transfer structures.

According to an embodiment, the method further comprises placing at least one support module plate within the enclosure in order to fill out the enclosure. Depending on the modular cold plate to be assembled there may be a need to add support module plate within the enclosure. This may be advantageous since it brings a modularity to the arrangement and method that ensures that the cold plate can be adjusted to the specific power electronic component to be cooled.

Other objectives, features and advantages of the disclosed embodiments will be apparent from the following detailed disclosure as well as from the drawings.

It is noted that embodiments of the present disclosure relate to all possible combinations of features recited in the claims. Further, it will be appreciated that the various embodiments described for the system as defined in accordance with the first aspect and the embodiments described for the method according to the second aspect are all combinable with each other.

### BRIEF DESCRIPTION OF THE DRAWINGS

This and other aspects of the present disclosure will now be described in more detail, with reference to the appended drawings showing embodiment(s) of the disclosure.
Figs. 1a and 1b schematically show a modular cold plate arrangement according to an exemplifying embodiment of the present disclosure.
Fig. 2 schematically shows module plates to be placed in a modular cold plate arrangement according to an exemplifying embodiment of the present disclosure.
Figs. 3a, 3b and 3c schematically show modular cold plate arrangements according to exemplifying embodiments of the present disclosure.
Figs. 4a, 4b and 4c schematically show a modular cold plate arrangement according to an exemplifying embodiment of the present disclosure.
Fig. 5 schematically shows different triply periodic minimal surfaces that may be included in a heat transfer structure of a modular cold plate arrangement according to exemplifying embodiments of the present disclosure.
Figs. 6a, 6b and 6c schematically show cell gradients for heat transfer structures of modular cold plate arrangements according to exemplifying embodiments of the present disclosure.
Figs. 7a and 7b schematically show pin-fin arrangements that may be used in a modular cold plate arrangement according to an exemplifying embodiment of the present disclosure.
Fig. 8 schematically shows a channel in a support module plate of a modular cold plate arrangement according to an exemplifying embodiment of the present disclosure.
Figs. 9a, 9b, and 9c schematically show different ways of creating a surface similar to a TPMS to be used in a modular cold plate arrangement according to an exemplifying embodiment of the present disclosure.
Fig. 9d shows two surfaces similar to a TPMS structure.
Fig. 10 shows a flowchart of a method according to an exemplifying embodiment of the present disclosure.

### DETAILED DESCRIPTION

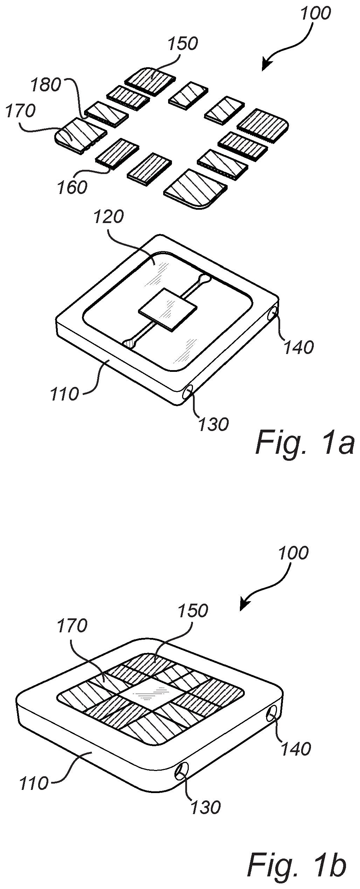

Figure 1a schematically shows a modular cold plate arrangement 100 according to an exemplifying embodiment of the present disclosure.

The modular cold plate arrangement 100 comprises a base plate 110 having an enclosure 120 configured to hold a cooling fluid. The modular cold plate arrangement 100 further comprises a fluid inlet 130 configured to allow a cooling fluid to enter the enclosure 120 and a fluid outlet 140 configured to allow a cooling fluid to leave the enclosure 120. Further, a plurality of thermal module plates 150 may be placed in the enclosure 120 of the base plate 110. At least one of the thermal module plates 150 comprises a heat transfer structure 160 configured to transfer heat to the cooling fluid. The heat may come from a power electronic component placed in thermal contact with the plurality of thermal module plates 150 and be transferred by the thermal module plates 150 to the cooling fluid. The modular cold plate arrangement 100 disclosed in Figure 1a further comprises a plurality of support module plates 170 comprising channels 180 for guiding the cooling fluid.

The cooling fluid may be any kind of liquid or gas to which heat may be transferred from the modular cold plate arrangement 100. The fluid inlet 130 and the fluid outlet 140 may be placed in any suitable location. The positioning of the fluid inlet 130 and the fluid outlet 140 in Figure 1a is merely used as an example. The cooling fluid entering the fluid inlet 130 may be configured to have a certain temperature and a certain pressure. The temperature of the cooling fluid and the pressure of the cooling fluid may be different when exiting the modular cold plate arrangement 100 via the fluid outlet 140. The temperature of the cooling fluid will change due to heat transfer to the cooling fluid from the cold plate arrangement 100, and in particular from the thermal module plates 170 and support module plates 150. The module plates 150, 170 are in thermal contact with a electronic component that generates heat, and this heat may then be transferred to the cooling fluid. The pressure of the cooling fluid may decrease as it moves through the modular cold plate arrangement 100 due to hydrodynamic resistance within the cold plate arrangement 100. While increasing the area of heat transferring material in the cooling fluid the area causing hydrodynamic resistance is generally also increased. Therefore, a combination between thermal module plates 150 that focus on thermal transfer to the cooling fluid and support module plates 170 that guides the cooling fluid may be advantageous.

Figure 1b schematically shows the modular cold plate arrangement 100 according to the exemplifying embodiment in Figure 1a when the arrangement 100 has been assembled.

The modular cold plate arrangement in Figure 1b comprises six thermal module plates 150 and six support module plates 170. Other combinations, such as arrangements with only thermal module plates 150, are available and will be discussed in relation to later Figures. The thermal module plates 150 may be arranged within the enclosure 120 in such a way that their position matches heated regions of the power electronic component which is to be cooled. The support module plates 170 may then be placed within the enclosure 120 in order to fill out the enclosure 120 and provide mechanical stability and support. When the module plates 150, 170 have been placed they may be joined by any joining technique. For example, the modular cold plate arrangement 100 may be placed in a vacuum brazing furnace so that the modular plates 150, 170 are joined together with each other and with the base plate 110.

A electronic component comprising or being a power electronic component may be configured to be placed on top of the thermal module plates 150 and the support module plates 170 and a pressure may be applied to ensure an efficient thermal connection between the modular cold plate arrangement 100 and the power electronic component. When the electronic component is heated a cooling fluid flowing through the modular cold plate arrangement 100 may receive heat from the modular plates 150, 170 and thusly cool the electronic component.

The electronic component may in some examples comprise a switching devices, such as thyristors or transistors (such as Insulated-gate bipolar transistors), that may be part of a HVDC converter.

It may be advantageous to only place the thermal module plates 150 at positions particularly exposed to heat generation, such as positions in which the heated regions of the power electronic component will be arranged. This since the thermal module plates 150 may be made of relatively expensive materials or made using relatively complicated manufacturing procedures. By also using the support module plates 170 the heat transfer can be optimized while at the same time keeping the costs low and increasing the simplicity of the arrangement 100. Further, the support module plates 170 can ensure that the cooling fluid is guided through the cold plate arrangement 100.

At least one of the thermal module plates 150 may comprise a heat transfer structure 160 configured to transfer heat from the electronic component to the cooling fluid. The heat transfer structure 160 may be at least partially submerged in the cooling fluid for dissipating heat to the cooling fluid. The heat transfer structure 160 may be fully submerged in the cooling fluid. The heat transfer structure 160 may be any conventional heat transfer structure 160. For example, the heat transfer structure 160 may be a plurality of pin-fins configured to be at least partially submerged in the cooling fluid and configured to transfer heat to the cooling fluid. The pin-fins are per say known in the art, however the thermal module plate 150 may comprise different amounts and geometries of these pin-fins depending on where they are placed in the enclosure 120. This can ensure a higher modularity for the cold plate and the arrangement 100 may therefore be adjusted to different power electronic components. The heat transfer structure 160 may be placed so that it is in contact with the base plate 110 and after placement of the full arrangement joined to the baseplate 110 using any known joining technique.

The heat transfer structure 160 may also include a plurality of cells comprising Triply Periodic Minimal Surfaces (TPMS) configured to be at least partially submerged in the cooling fluid to transfer heat to the cooling fluid. The TPMS cells may allow for a maximized heat transfer to the cooling fluid for cooling the power electronic component by maximizing the area of the heat transfer structure 160 in contact with the cooling fluid. The TPMS cells may be any kind of TPMS cells and may also vary throughout the modular cold plate arrangement as will be described in relation to later figures.

At least one of the support module plates 170 may comprise a channel 180 configured to be at least partially submerged in the cooling fluid. In the embodiment shown in Figure 1a all support module plates comprises channels 180. The channels 180 may dissipate heat from the support module plates to the cooling fluid and may also direct the cooling fluid ensuring that the pressure drop in the cold plate arrangement 100 is kept at a minimum. Further, the support module plates 170 may ensure that the modular cold plate arrangement 100 can handle a high pressure in case the power electronic component is pressed towards the modular cold plate arrangement 100.

The support module plates 170 may further comprise a number of pin-fins. The pin-fins may form the channels 180. The pin-fins may have any shape and geometry and will be discussed further in relation to later figures.

The module plates 150, 170 may be fastened to the base plate 110 after they have been placed in their final positions. They may be joined to the base plate 110 through any conventional method. For example, a brazing sheet may be placed in the enclosure 120 between the base plate 110 and the module plates 150, 170. The modular cold plate arrangement 100 may then be heated so that the module plates 150, 170 are joined to the base plate 110. The module plates 150, 170 may also be fastened with other methods, for example with laser welding.

The base plate 110 may be made from any suitable material. It may for example be made from a metal. The metal may for example be aluminium or copper. The module plates 150, 170 may be made from any suitable material or any suitable combination of materials. The module plates 150, 170 may for example be made from metal materials such as aluminium or copper.

In general, the thermal module plates 150 and the support module plates 170 differ in their thermal transfer properties and how well they guide the cooling fluid. The thermal module plates 150 may be configured to maximize the heat transfer to the cooling fluid. In order to achieve this, they may include the heat transfer structures 160, for example a number of pin-fins or structure including TPMS-cells. On the other hand, the support module plates 170 are configured to complete the cold plate arrangement by providing structural support and some heat transferring means while at the same time not impacting the pressure drop of the cooling fluid negatively to any larger degree. In other words, the thermal module plates 150 may be made without specific regard or consideration to the effects on the pressure drop while the support module plates 170 may be made without specific regard or consideration towards heat transfer.

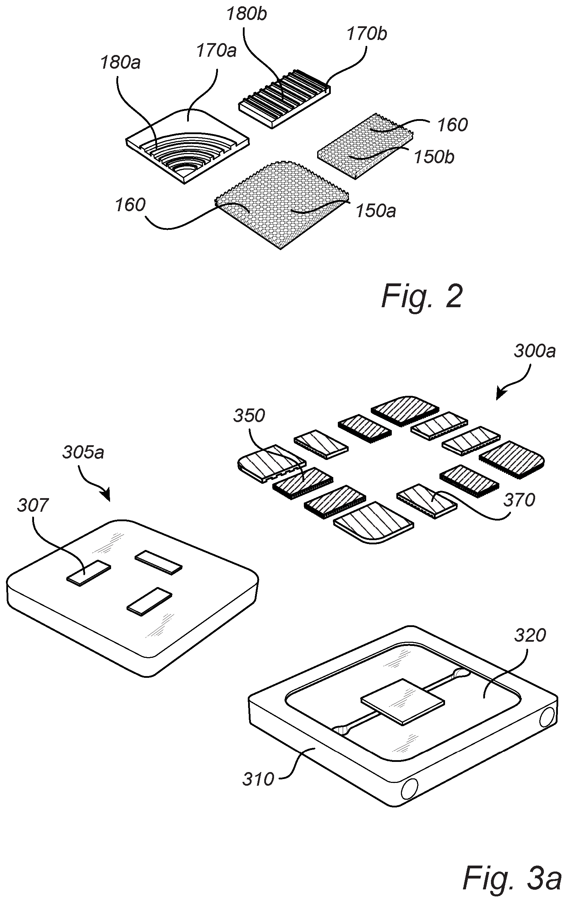

In Figure 2 module plates 150, 170 to be placed in a modular cold plate arrangement according to an exemplifying embodiment are disclosed.

Depending on the geometry of the base plate and the enclosure within the base plate different shapes of the module plates 150, 170 may be needed. It is for example conceivable that some of the thermal module plates 150a and the support module plates 170a may form corner pieces, and that some form straight or middle pieces 150b, 170b interconnecting the corner pieces. The thermal module plates 150a,150b may comprise heat transfer structures configured to be at least partially submerged in a cooling liquid in order to transfer heat. The support module plates 170a, 170b may comprise at least one channel 180a, 180b for guiding the cooling liquid and for transferring heat to the cooling liquid. A suitable combination of modular plates, 150a, 150b, 170a, 170b may both maximise the heat transfer to the cooling liquid and at the same time ensure that the pressure drop is not too high.

The thermal module plates 170 and support module plates 150 may be made from any suitable materials. The module plates 170, 150 may for example be made from a material configured to transfer heat. In general, metal materials, are used for transferring heat in cold plates. The module plates 170, 150 may be made of a metal, for example aluminium.

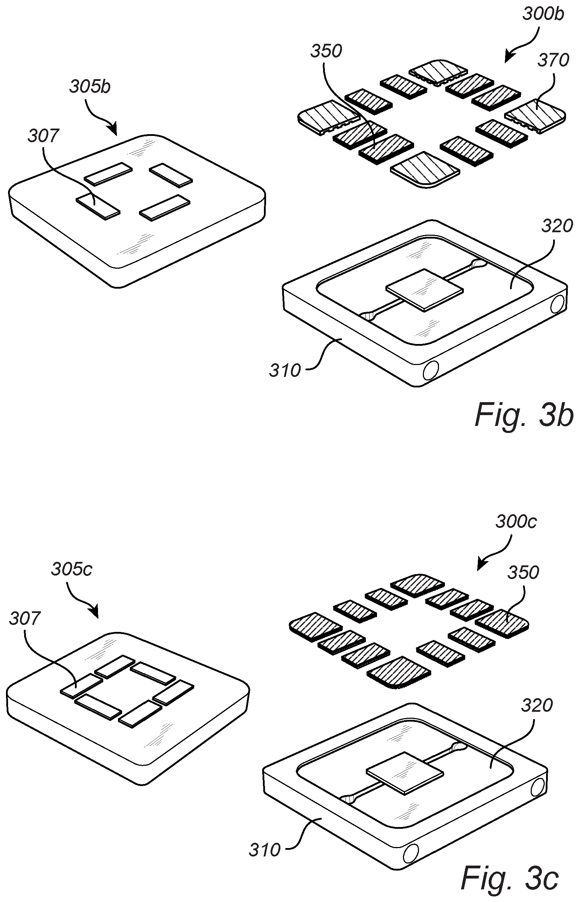

In Figure 3a, 3b and 3c modular cold plate arrangements 300a, 300b, 300c according to exemplifying embodiments are disclosed.

Due to the modularity of the modular cold plate arrangements 300a, 300b, 330c can be adjusted to match different electronic components. As exemplary embodiments, the modular cold plate arrangements 300a, 300b, 300c in Figure 3a, 3b and 3c are presented. They are configured to cool different electronic components 305a, 305b, 305c.Theelectronic components 305a, 305b, 305c may for example be used in HVDC-applications.

In Figure 3a an electronic component 305a is presented comprising three submodules 307. During use of the electronic component 305a these submodules 307 may be heated. It may therefore be advantageous to adapt the cold plate 300a after the positions of the submodules 307. As can be seen in Figure 3a the thermal module plates 350 are placed in the enclosure 320 of the base plate 310 so that they match the positions of the submodules 307 when the electronic component 305a is placed in contact with the modular cold plate arrangement 300a. Since the electronic component 305a of Figure 3a only has three submodules 307 the modular cold plate arrangement can be filled out with support module plates 370. The support module plates 370 may be placed within the enclosure 320 to guide the cooling fluid in order to allow for a minimized pressure drop. In this specific embodiment six support module plates 370 and six thermal module plates 350 are arranged within the enclosure to for the cold plate 300a. Out of the six support module plates, two are corner pieces as described in relation to Figure 2 and four are straight middle pieces. Similarly, four out of the six thermal module plates 350 are straight middle pieces and two are corner pieces. It is understood that this embodiment merely shows an example and that in general any number of thermal module plates 350 and any number of support module plates 370 may be used. For example, the size of the module plates 350, 370 may be larger or smaller, i.e. a larger or smaller number of module plates 350, 370 may be needed.

In Figure 3b an electronic component 305b is presented comprising four submodules 307. The modular cold plate arrangement 300b may then be assembled to match the electronic component 305b. In the example in Figure 3b the modular cold plate arrangement 300b comprises eight thermal module plates 350 and four support module plates 370.

In Figure 3c an electronic component 305c is presented comprising six submodules 307. In this exemplifying embodiment the modular cold plate arrangement 300c comprises twelve thermal module plates 350 and no support module plates.

It is appreciated that, in general, any number of thermal module plates 350 and any number of support module plates 370 may be used to assemble the modular cold plate arrangement 300a, 300b, 300c. In general, the more thermal module plates 350 used in the arrangement the better heat transfer from the electronic component 305a, 305b, 305c to the cooling fluid is achieved. However, in case the electronic component 305a, 305b, 305c comprises regions that are not heated as much as the submodules 307 it may be advantageous to also use support module plates 370 in the arrangement.

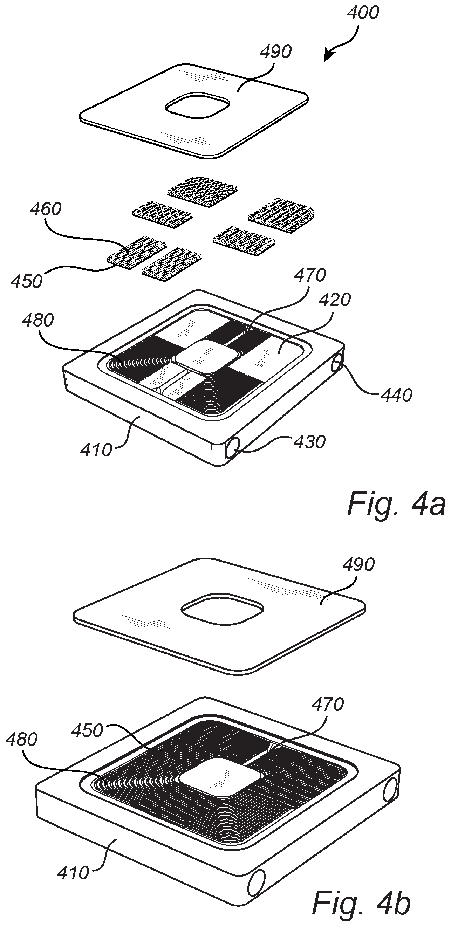

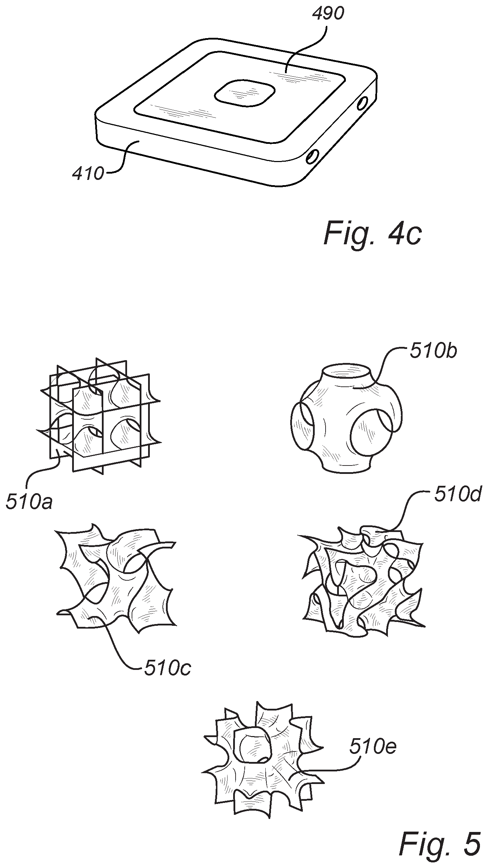

In Figures 4a, 4b and 4c a modular cold plate arrangement 400 according to an exemplifying embodiment is disclosed.

Figure 4a discloses a modular cold plate arrangement 400 before it is assembled. The modular cold plate arrangement 400 comprises a base plate 410 with an enclosure 420 configured to hold a cooling fluid. A fluid inlet 430 for allowing the cooling fluid to enter is provided in the base plate 410. The base plate 410 also has a fluid outlet for allowing the cooling fluid to leave the enclosure 420. The modular cold plate arrangement 400 further comprises a plurality of thermal module plates 450 configured to be arranged within the enclosure 420. In the exemplifying embodiment in Figure 4a the modular cold plate arrangement 400 comprises six thermal module plates 450. The thermal modular plates 450 comprises heat transfer structures 460 configured to transfer heat to the cooling fluid. In the exemplifying embodiment in Figure 4a the thermal module plates 450 include heat transfer structures 460 made out of multiple cells of triply periodic minimal surfaces. The heat transfer structures 460 are configured to be at least partially submerged in a cooling fluid to transfer heat from a power electronic component to the cooling fluid.

The base plate 410 further comprises regions 470. The regions in Figure 4a all include a plurality of channels 480 configured to be at least partially submerged in the cooling fluid. The channels 480 will also be able to guide the cooling fluid through the enclosure 420. It is clear that the number of channels may vary between the regions. It is further clear that the width of the channels can vary. Further, in general, the channels may be formed in any conventional way. They may for example be made by additive manufacturing or by etching away material of the base plate. The regions may further comprise a number of pin-fins where at least one of the channels 480 is formed by the pin-fins. The pin-fins may have any shape and size and may also be split, forming at least channel through the pin-fins. Further, it is envisioned that at least one channel 480 may have at least one wall that is corrugated or wavy. This may help in minimizing the pressure drop over the modular cold plate arrangement 400. The regions 470 may be compared to the support module plates discussed in relation to previous figures. However, embodiments with both regions 470 and support module plates are plausible.

The modular cold plate arrangement 400 disclosed in Figure 4a further comprises a lid portion 490 configured to be arranged in the enclosure on top of the thermal module plates 450 and the regions 470. The lid portion may be fastened to the base plate 410 using any conventional joining technique, such as vacuum brazing or laser welding. The lid portion 490 may be advantageous since it ensures that cooling fluid that enter the liquid inlet 430 stays within the enclosure until it leaves through the liquid outlet 440. The channels 480 of the regions 470 may be configured to extend from the base plate 410 and up to the lid portion 490. When a power electronic component is placed in contact to the lid portion 490, heat may then be transferred to the channels 480 and also to the thermal module plates 450.

The assembling order of the modular cold plate arrangement is disclosed in Figures 4a, 4b and 4c. In a first step, a base plate 410 corresponding to a certain power electronic component to be cooled is provided. The base plate 410 has a number of regions 470 that include channels 480 that may be integrally formed within the base plate 410. The channels 480 in the regions 470 may be adapted to guide a cooling fluid through the cold plate arrangement 400. Further, a plurality of thermal module plates 450 are provided to be arranged within the enclosure 420 at locations matching the heated regions of the electronic component to be cooled. In Figure 4b the thermal module plates 450 have been placed in their corresponding positions within the enclosure 420. The thermal module plates 450 may be joined with the base plate 410 using any common joining technique. For example, the thermal module plates 450 may be placed on a brazing sheet which when heated fastens the thermal module plate 450 to the base plate 410. In Figure 4c the lid portion is placed on top of the regions 470 and thermal module plates 450 and is fastened. The lid portion 490 may when fastened be in contact with the channels 480 and the thermal module plates 450. An electronic component may then be placed on the lid portion and when a cooling fluid is introduced to the arrangement 400 the electronic component may be cooled. It is understood that the number of thermal module plates 450 placed in the arrangement 400 may vary depending on the power electronic component, for example in a similar way as described with relation to Figures 3a-3c. The lid portion 490 may be joined together with the base plate 410 using any common joining technique, for example laser welding or vacuum brazing.

Figure 5 schematically discloses a variety of triply periodic minimal surfaces 510a, 510b, 510c, 510d, 510e that may be included in a heat transfer structure of a thermal module of a modular cold plate arrangement.

A minimal surface is a surface that is locally area minimizing, i.e. a small piece has the smallest possible area for a surface spanning the piece. Minimal surfaces have zero mean curvature, i.e. the sum of the curvatures at each point is zero. Minimal surfaces with crystalline structure, repeating themselves in three dimensions, are triply periodic.

In general, a TPMS is a minimal surface in three dimensions that is invariant under a rank-3 lattice of translations. The TPMS have symmetries of a crystallographic group with examples such as cubic, tetragonal, rhombohedral and orthorhombic. Most TPMS are free of self-intersections

Using a heat transfer structure with cells of TPMS, or structures mimicking such geometries, may be advantageous since the area in contact with the cooling fluid may be maximized and thusly the heat transfer may be increased. The heat transfer structure may include a plurality of cells in any order or direction. The heat transfer structure may include TPMS structures of only one type or a mixture between multiple types.

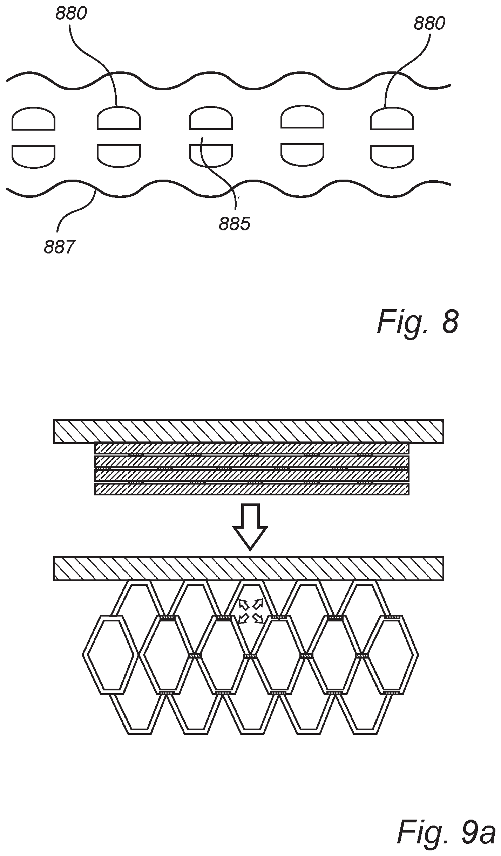

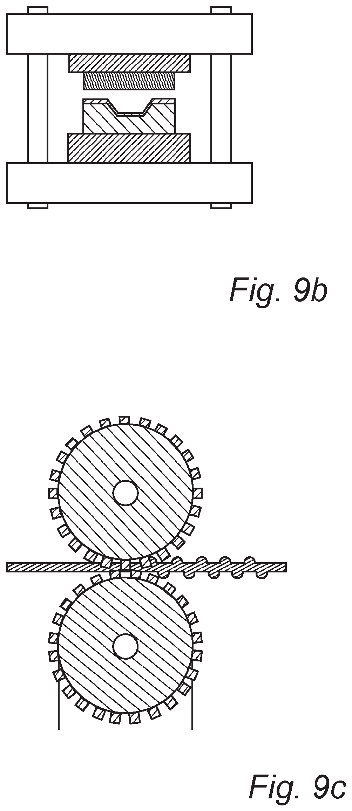

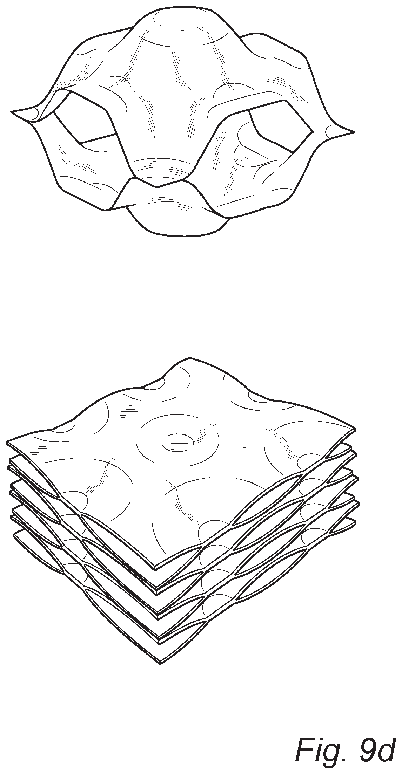

The TPMS 510a, 510b, 510c, 510d, 510e used may be any know TPMS such as any variation of Schoens surfaces, Schwarz surfaces or Fisher-Koch surfaces. It is also envisioned that surfaces mimicking or being at least partially similar to TPMS may be used. A way for creating such a structure is described in relation to Figure 9.

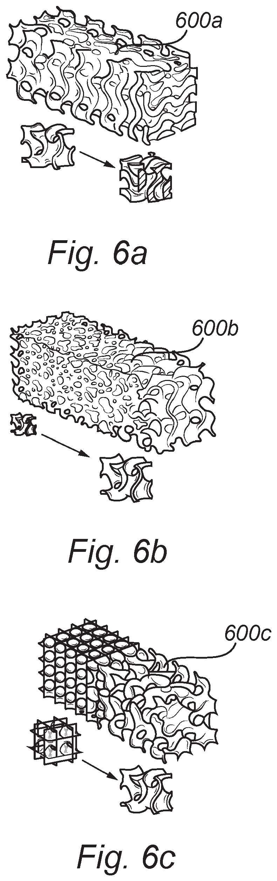

Figures 6a, 6b and 6c shown cells gradient for heat transfer structures of modular cold plate arrangements according to exemplifying embodiments of the present disclosure.

By combining multiple TPMS a heat transfer structure 660a, 660b, 660c (that can be part of a thermal module plate for a modular cold plate arrangement) can be created. Figures 6a, 6b and 6c shows examples of such heat transfer structures 660a, 660b, 660c. In general, certain features of the plurality of cells of TPMS may vary throughout the heat transfer structure 660a, 660b, 660c.

In Figure 6a the cell density, or wall or surface thickness of the surfaces varies along the heat transfer structure. In Figure 6b the cells of TPMS varies in size. In Figure 6c the type of TPMS varies throughout the heat transfer structure. By varying one or more of these features in a heat transfer structure 660a, 660b, 660c the thermal module plates may be even more adjustable after the requirements of the power electronic components to be cooled. The variance in surface thickness, cells size or cell type can ensure that the heat transfer capabilities is controlled at a very detailed level which may be advantageous when assembling the modular cold plate arrangement and adjusting it to a power electronic component. The gradients may be in the flow direction of the cooling liquid, perpendicular to the flow direction of the cooling liquid, or in any other direction.

It is further envisioned to fill certain areas of the TPMS-structures with solid material. This since certain TPMS-structures have inherent features leading to dead-flow zones, which can cause particle accumulation and negatively impact the pressure drop in the cooling fluid. By filling these areas with a solid material, these problems may be mitigated. The modified TPMS-structures created may therefore be advantageous.

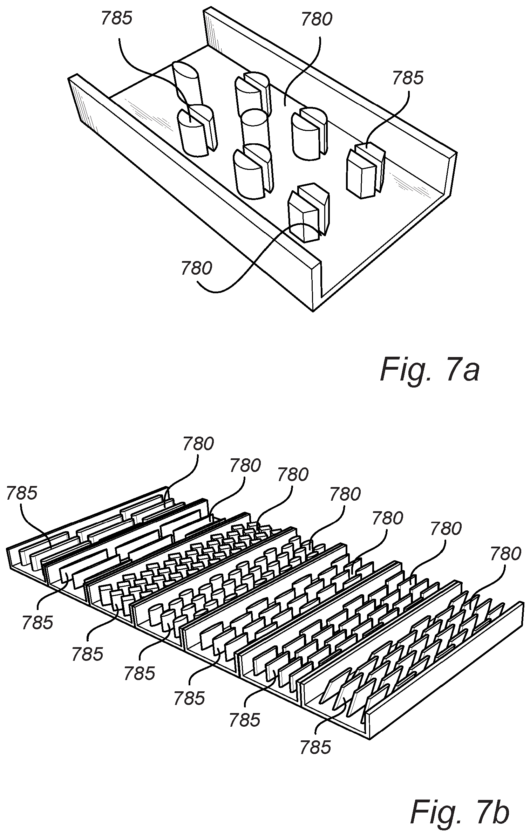

Figure 7a and 7b schematically shows pin-fin arrangements that may be used in a modular cold plate according to an exemplifying embodiment.

As described throughout this application a modular cold plate arrangement may comprise a number of thermal module plates and possibly a number of support module plates. Both the thermal module plates and the support module plates may include a number of pin-fins for transferring heat from the modular cold plate arrangement to the cooling fluid surrounding. Depending on the use of the module plate the pin-fins may be arranged in different configurations. For example, in general, in a support module plate the pin-fins may be arranged for forming channels for guiding the cooling fluid. In this way, the pin-fins may transfer heat to the cooling fluid while at the same time ensure that the pressure drop over the cold plate is kept low. For the thermal module plates, the pin-fins may instead by organised in order to maximize thermal dissipation to the cooling fluid in order to decrease the temperature of the power electronic component as much as possible. By mixing thermal module plates and support module plates throughout the modular cold plate arrangement, a balance between heat transfer and acceptable pressure drop can be achieved.

In Figure 7a an exemplary configuration of pin-fins 785 forming a number of channels 780 is disclosed. The pin-fins 785 in this exemplifying embodiment includes pin-fins 785 of different shapes and sizes. For example, some pin-fins 785 have a circular cross section, whereas some may be elliptical or hexagonal. Further, some of the pin-fins 785 are split to create channels 780 between the pin-fins. The channels 780 are formed between the pin-fins 785, and between the walls and the pin-fins 785. By splitting the pin-fins 785 the thermal interface between the cooling fluid and the modules can be further enlarged ensuring a better heat transfer. At the same time, split pin-fins 785 allows for channels 780 between the pin-fins 785 for guiding the cooling fluid which is advantageous for the pressure drop.

Figure 7b discloses a variety of pin-fins 785 that may be used in module plates of the present invention. The pin-fins 785 may be used in thermal module plates and in support module plates depending on the thermal requirements of the electronic component to be cooled. The pin-fins 785 in Figure 7b are arranged for forming channel 780 and may for example be part of a support module plate described in relation to earlier Figures.

Figure 8 discloses a channel 880 in a support module plate of a modular cold plate arrangement according to an exemplifying embodiment.

It is advantageous to keep the pressure drop over a cold plate as low as possible. One way to decrease the pressure drop is by using channels with at least one corrugated wall 887. This is advantageous since the cross-sectional area along the channel, for the fluid to flow in, can be kept constant or consistent throughout the channel. Further, the area in contact with the cooling fluid will increase which will increase the thermal transfer to the cooling fluid. A corrugated wall 887 may for example have a ridged or wavy form as seen in Figure 8.

In Figures 9a, 9b and 9c different manufacturing methods for creating structures similar to TPMS structures are discloses

TPMS structures may be hard to manufacture in a large quantity. Replacing TPMS structures in the heat transfer structures with advanced structures using conventional construction methods may therefore be advantageous. These structures may be seen as simplified TPMS structures, or TPMS mimicking structures. Figure 9a, 9b and 9c describes three different methods for manufacturing simplified TPMS structures.

By using hydrostatic pressure forming, also known as hydroforming, metal sheets can be shaped or deformed into simplified TPMS structures. A schematic figure on how to use hydrostatic pressure forming to create simplified TPMS structures is disclosed in Figure 9. The method of hydroforming is known by the skilled man per se, but not for creating simplified TPMS structures or parts of such structures. The process may for example include providing a stack of metal sheets. The sheets may be any metal, for example aluminium. The sheets may also be made from a combination of different materials. The sheet may then be spot-welded in a staggered configuration. Subsequently a pressure applied by a hydraulic medium such as oil or air can cause the material to stretch and deform. The metal may then expand to simplified TPMS structures due to the spot welding and applied pressure. The simplified TPMS structures may then be used in applications such as the modular cold plate arrangement as discussed within the present disclosure.

Sheet metal pressing is a different way of manufacturing structures similar to TPMS structures and is schematically disclosed in Figure 9b. Here, half of a simplified TPMS structure may be formed by conventional metal pressing. By joining together two halves a full simplified TPMS structure may then be made.

Similarly, as described in Figure 9c halves of the simplified TPMS structures may be created using sheet metal rolling. By continuous rolling metal sheets may be deformed creating parts of the simplified TPMS structures for later joining.

Examples of the simplified TPMS structures are disclosed in Figure 9d. These may be used for the heat transfer structures as described within the present application. They may be made from any material with suitable for heat transfer and may be used, for example, in a modular cold plate arrangement according to the present disclosure.

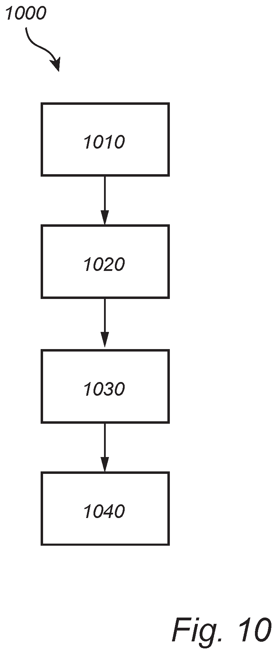

Figure 10 shows a flowchart 1000 of a method according to an exemplifying embodiment of the present disclosure.

The cold plate arrangement according to the invention is modular and adaptable to different electronic components. In order to assemble the modular cold plate arrangement, the method 1000 disclosed in Figure 10 is provided. The method 1000 comprises providing 1010 a base plate with an enclosure configured to receive at least one thermal module plate. The base plate may be any base plate discussed throughout the present disclosure. For example, the base plate may include regions in the enclosure with premade channels. The base plate may also not include these regions. The method 1000 may further include placing 1020 at least one thermal module plate within the enclosure at a location matching a position of a heated region of an electronic component configured to be cooled. Since different electronic components will have different characteristics they may be heated differently. Therefore, it may be advantageous to place the thermal module plates at locations within the enclosure so that the thermal module plates maximise the heat transfer from the electronic component to the cooling fluid when the modular cold plate arrangement is brought into contact with the electronic component. Depending on the electronic component a varying number of thermal module plates may be used.

The method may further comprise placing 1030 at least one support module plate within the enclosure in order to fill out the enclosure. Once the support module plates have been placed, they may be joined together with the thermal module plates and the base plate. This may be done with any joining technique, for example with vacuum brazing.

The method may further comprise placing 1040 a lid element on top of the thermal module plates. In case the base plate includes regions and/or the thermal module plates do not have their own top plate, a lid element may be needed. This lid element may then be fastened to the base plate using any joining technique. The lid element may ensure that the cooling fluid entered into the arrangement does not escape or spill.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, and the appended claims. In the appended claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A modular cold plate arrangement (100) configured to cool an electronic component, comprising:
a base plate (110) comprising an enclosure (120) configured to hold a cooling fluid,
a fluid inlet (130) configured to allow a cooling fluid to enter the enclosure,
a fluid outlet (140) configured to allow the cooling fluid to leave the enclosure, and
a plurality of thermal module plates (150) arranged in the enclosure formed in the base plate,
wherein at least one of the plurality of the thermal module plates comprises a heat transfer structure (160) configured to transfer heat from the electronic component to the cooling fluid.

2. The modular cold plate arrangement according to claim 1, wherein the heat transfer structure comprises a plurality of pin-fins (785) configured to be at least partially submerged in the cooling fluid to transfer heat to the cooling fluid.

3. The modular cold plate arrangement according to claim 1, wherein the heat transfer structure comprises a plurality of cells comprising triply periodic minimal surfaces (510a, 510b, 510c, 510d, 510e) configured to be at least partially submerged in the cooling fluid to transfer heat to the cooling fluid.

4. The modular cold plate arrangement according to claim 3, wherein the plurality of cells comprises a gradient in either cell density, cell size or cell type.

5. The modular cold plate arrangement according to any one of the preceding claims, further comprising at least one support module plate (170), wherein at least one of the at least one support module plates comprises at least one channel (180) configured to be at least partially submerged in the cooling fluid.

6. The modular cold plate arrangement according to claim 5, wherein the at least one support module plates comprises a plurality of pin-fins (785), wherein the plurality of pin-fins are arranged to form the at least one channel.

7. The modular cold plate arrangement according to any one of the preceding claims, wherein the base plate further comprises at least one region (470) comprising at least one channel (480) configured to be at least partially submerged in the cooling fluid.

8. The modular cold plate arrangement according to claim 7, wherein the at least one region comprises a plurality of pin-fins, and wherein at least one of the at least one channel is formed by the plurality of pin-fins.

9. The modular cold plate arrangement according to claim 6 or claim 8, wherein the plurality of pin-fins comprises split pin-fins forming at least one of the at least one channels through the pin-fins for guiding the cooling fluid.

10. The modular cold plate arrangement according to claims 6, 7, 8 or 9, wherein at least one wall (887) of the at least one channel is corrugated.

11. The modular cold plate arrangement according to any one of claims 7-10, further comprising a lid portion (490) configured to be arranged in the enclosure on top of the plurality of thermal module plates and the at least one region.

12. The modular cold plate arrangement according to any one of the preceding claims, wherein the plurality of thermal module plates are distributed within the enclosure to match regions particularly exposed to heating.

13. The modular cold plate arrangement according to any one of the preceding claims, wherein the heat transfer structure of at least one of the plurality of thermal module plate is made using additive manufacturing.

14. A method (1000) for assembling a modular cold plate arrangement (100) according to claims 1-14, the method comprises:
providing (1010) a base plate with an enclosure configured to receive at least one thermal module plate,
placing (1020) at least one thermal module plate within the enclosure at a location matching a position of a heated region of an electronic component configured to be cooled.

15. The method according to claim 14, further comprising
placing (1030) at least one support module plate within the enclosure in order to fill out the enclosure.
